Europäisches Patentamt

European Patent Office

Office européen des brevets

(11) Publication number: **0 331 811**
**A2**

## EUROPEAN PATENT APPLICATION

(21) Application number: 88120896.1

(22) Date of filing: 14.12.88

(51) Int. Cl.⁴: **H01L 21/84 , H01L 21/20 , H01L 21/268**

(30) Priority: 18.12.87 JP 321808/87

(43) Date of publication of application:
13.09.89 Bulletin 89/37

(84) Designated Contracting States:
DE FR GB

(71) Applicant: **FUJITSU LIMITED**
**1015, Kamikodanaka Nakahara-ku**
**Kawasaki-shi Kanagawa 211(JP)**

(72) Inventor: **Hasegawa, Mitsuhiko c/o FUJITSU**
**LIMITED**
**Patent Department 1015 Kamikodanaka**
**Nakahara-ku**
**Kawasaki-shi Kanagawa 211(JP)**

(74) Representative: **Sunderland, James Harry et al**
**HASELTINE LAKE & CO Hazlitt House 28**
**Southampton Buildings Chancery Lane**
**London WC2A 1AT(GB)**

(54) Semiconductor devices with silicon-on-insulator structures.

(57) For fabricating a CMOS SOI structure on a silicon substrate (1) having a (110) plane an insulating SiO₂ layer (2) is formed; an opening (2′) is formed in the SiO₂ layer to expose a part of the substrate (1); a polycrystalline or amorphous silicon layer (3) is deposited on the SiO₂ (2) and in the opening (2′); the deposited silicon layer (3) is divided into islands (3A, 3B) so that a first island (3A) includes the opening (2′) whilst a second island (3B) does not; a laser light (LB) is irradiated onto the islands (3A, 3B) so as to melt the islands; when the laser light irradiation is discontinued the melted islands are recrystallized so that the first island (3AR) forms a (110) plane whilst the second island (3BR) forms a (100) plane; and on the first island (3AR) a p-channel MOS FET is fabricated whilst on the second island (3BR) an n-channel MOS FET is fabricated.

FIG. 3(a)

FIG. 3(d)

FIG. 3(g)

## Semiconductor devices with silicon-on-insulator structures.

This invention relates to a semiconductor devices with silicon-on-insulator (SOI) structures.

Extensive efforts have been made to enhance operating speed of semiconductor devices. Some of these efforts have been directed towards provision of higher mobility for carriers in semiconductor material. It is well-known that carrier mobility depends on crystal orientation, i.e. depends on Miller indices of the plane indicating crystal orientation. Typical values of the field effect mobility (referred to hereinafter as mobility) of two kinds of carriers in silicon of two different crystal orientations are compared herebelow. The data relates to silicon doped with an impurity, arsenic in a p-type substrate or boron in an n-type substrate, each to a concentration as high as $10^{14}$ to $10^{15}$ $cm^{-3}$. The unit of mobility is $cm^2V^{-1}$ $sec^{-1}$.

| Miller Indices | Carrier: | Electron | Positive Hole |
|---|---|---|---|
| (100) | | 450 | 150 |
| (110) | | < 400 | 190 |

Thus, it is seen that the mobility of a positive hole in a silicon substrate having a (100) plane is only one-third of that of an electron. Therefore, the channel width of an FET (field effect transistor) using positive holes must be widened to three times that of an FET using electrons if the current capacity is to be kept equal to that of the FET using electrons. This is disadvantageous in that it militates against enhanced integration density.

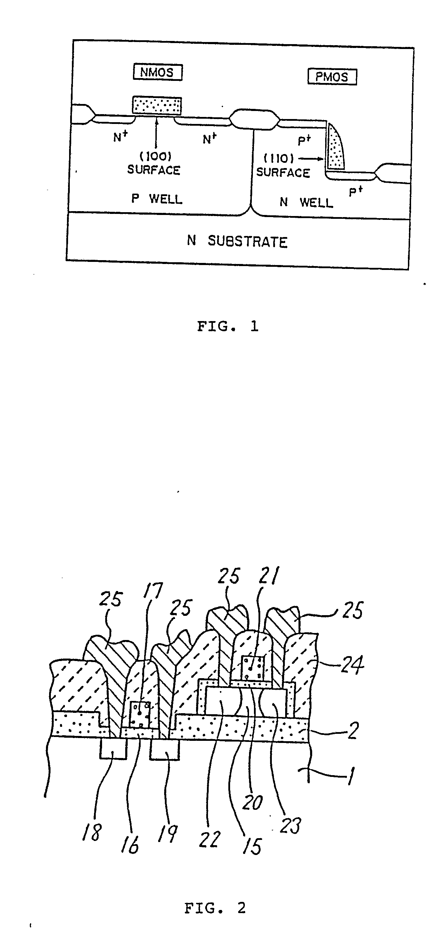

Therefore, it has been proposed to employ a (100) plane for an n-channel MOS FET, using electrons as carriers, and a (110) plane for a p-channel MOS FET using positive holes as carriers. One such proposal is reported in "Submicron 3D Surface Orientation Optimized CMOS Technology" by Kinugawa, et al., Symposium on VLSI Technology, San Diego, 28th to 30th May 1986. The structure reported therein is schematically illustrated in Fig. 1, where an n-channel MOS FET is fabricated on a (100) surface of a silicon substrate and a p-channel MOS FET is fabricated on a (110) surface provided by a plane cut vertically to the (100) surface. Another CMOS structure has been disclosed by Kasai in Japanese unexamined patent publication Tokukai Sho 63-80561, in which side planes cut vertically to main substrate surfaces are used for forming transistors. However, there are problems with these proposed structures in that the fabrication processes needed, particularly the photolithography processes, are quite complicated due to the employment of vertically cut surfaces. Furthermore, another problem arises with these structures in that a parasitic thyristor causes a latch-up phenomena between the p-type FET and n-type FET.

In order to avoid the problems involved in using vertically cut surfaces for transistor formation, there has been proposed by the inventor of the present invention a partial SOI structure as shown in Fig. 2. Directly on an n-type silicon substrate 1, having a (110) surface plane, there is fabricated a p-channel MOS FET, which is composed of p-type source-and-drain regions 18 and 19, an insulating $SiO_2$ layer 16 as a gate insulation layer, a gate electrode 17, passivating PSG (phospho-silicate glass) layer 25 and source and drain electrodes 25. An N-channel MOS FET having an SOI structure is composed of: a p-type silicon island 15, having a (100) surface plane, formed on an $SiO_2$ layer 2, n-type source-and-drain regions 22 and 23 locally formed in the silicon island 15, an insulating $SiO_2$ layer 20 forming a gate insulating layer, a silicon gate electrode 21, passivating PSG layer 24, and source and drain electrodes 25. A problem attaching to the use of this structure is that an advantage of SOI structure, that an isolation process can be carried out by using only an etching process, is not enjoyed.

An embodiment of the present invention can provide a high-speed CMOS transistor.

An embodiment of the present invention can provide a CMOS of a fully SOI structure suffering no latch-up effect such as is mentioned above.

An embodiment of the present invention can provide a simple and reliable method for fabricating an SOI CMOS device.

An embodiment of the present invention can provide for fabrication of a high-speed CMOS (complementary metal oxide semiconductor) device having an SOI structure.

In a method of fabricating a semiconductor device embodying the present invention, an insulation layer is formed on a silicon substrate having a (110) plane; an opening is made in the insulation layer so as to expose a part of the substrate; polycrystalline or amorphous silicon is deposited on the insulation layer and in the opening; the deposited silicon layer is divided into a plurality of islands, where a first island contacts the substrate through the opening whilst a second island is isolated from the substrate; the islands are heated so as to melt and are then cooled, then the first island is recrystallized to form a (110) plane whilst the second island forms a (100) plane; and a p-channel MOS FET is formed on the first island whilst an n-channel MOS FET is formed on the second island.

Reference is made, by way of example, to the accompanying drawings, in which:-

Fig. 1 is a cross-sectional side view of a prior art proposal for a "3D Surface Orientation Optimized CMOS" structure utilizing a vertically cut substrate;

Fig. 2 is a cross-sectional side view of a proposal for a CMOS structure partially employing an SOI structure;

Figs. 3 provide schematic cross-sectional side views illustrating fabrication steps in formation of a fully SOI CMOS according to an embodiment of the present invention;

Figs. 4 provide schematic plan views corresponding to some of the fabrication steps of Figs. 3;

Figs. 5 provide schematic cross-sectional side views illustrating additional fabrication steps to those of Figs. 3; and

Fig. 6 provides schematic plane views corresponding to fabrication steps of Figs. 5.

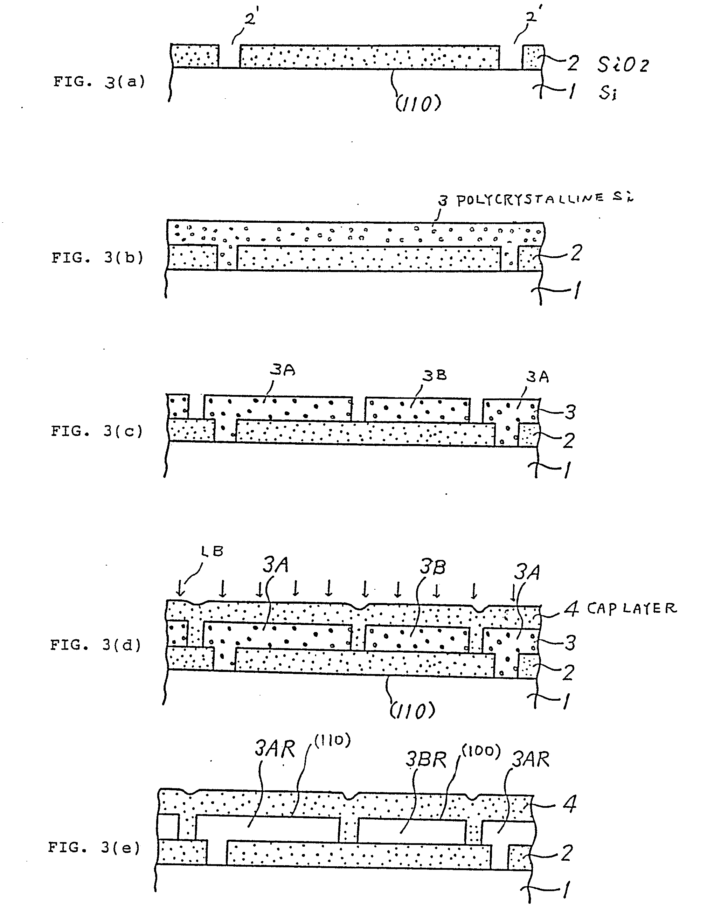

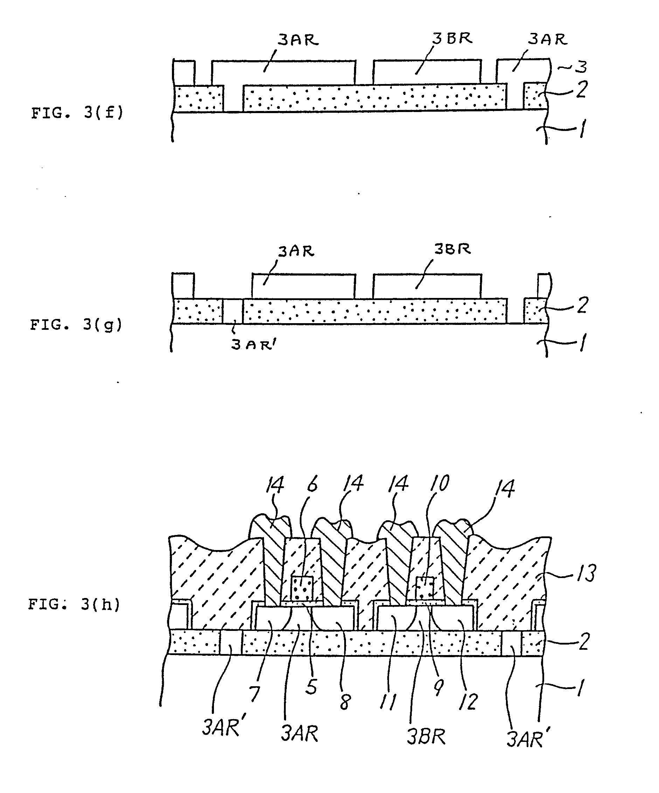

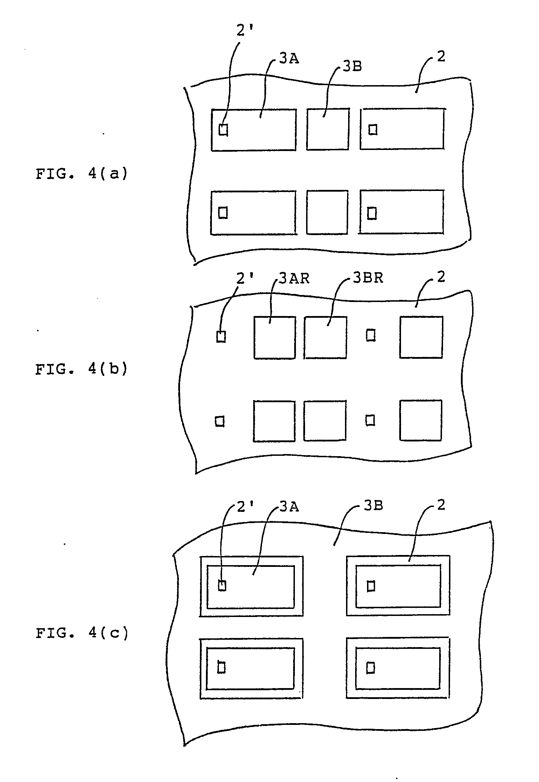

Referring to Figs. 3 and Figs. 4, process steps of an embodiment of the present invention will be described.

On a silicon substrate 1 (of either n- or p-type) having a (110) surface plane, an $SiO_2$ (silicon dioxide) insulation layer 2 is formed, up to approximately 1 $\mu$m thick, by thermal oxidization of the substrate 1. An opening 2′ typically 4 $\mu$m square, at least 0.7 $\mu$m diameter, is etched in the $SiO_2$ layer 2 by a lithography technique (e.g. by patterning a photoresist thereon and employing RIE (reactive ion etching) using, for example, $CHF_3$ (methane trifluoride gas) so that a part of the (110) surface of the substrate 1 is exposed, as shown in Fig. 3(a).

Next, a polycrystalline silicon layer 3 is deposited all over the $SiO_2$ layer 2, and in the opening 2′, by a CVD (chemical vapor deposition) method. The layer 3 has a thickness of approximately 4000 Å. This layer is shown in Fig. 3(b). In place of polycrystalline silicon layer 3, there may be deposited an amorphous silicon layer of the same thickness by, for example, a sputtering method.

Next, the deposited silicon layer 3 is patterned so as to be divided into a plurality of islands, for example by a photolithography technique, i.e. patterning a photoresist film on the deposited silicon layer 3 to cover the portions to remain as islands and then removing exposed portions of the silicon layer 3 by a wet etching method using, for example, a mixture of hydrofluoric acid and nitric acid solution. Thus, islands are formed which are isolated from each other. The lay-out of these divided islands is as follows. A first island 3A, used subsequently to provide a (110) plane, is patterned so that the island includes/contacts the opening 2′. A second island 3B, used subsequently to provide a (100) plane, is patterned so that the island does not include/contact the opening 2′. First and second islands 3A and 3B which form a pair in a subsequently formed CMOS structure are generally located adjacent to each other. This state is shown in Fig. 3(c) and Fig. 4(a).

Next, a cap layer 4, for example an $SiO_2$ film approximately 5000 Å thick and an $Si_3N_4$ (silicon nitride) film thereon approximately 300 Å thick, is formed all over the islands as shown in Fig. 3(d). Both the $SiO_2$ film and the $Si_3N_4$ film may be formed using CVD methods. The cap layer 4 reduces reflection of laser light irradiated on to the structure from 85% to 60 to 70%.

Next, with the substrate 1 is heated up to approximately 450° C using suitable heating apparatus, such as an electric heater (not shown in the Figure), a laser light beam LB of approximately 500 nm wavelength, which is easily absorbed by silicon, generated by continuous wave laser oscillation of argon gas, is irradiated on to the islands 3A and 3B through the cap layer 4. Typically, the laser light beam LB is of 15 watts output, having a beam spot size of approximately 40$\mu$m and a scanning speed of approximately 15 cm/sec.; accordingly, the deposited silicon forming the islands 3A and 3B are melted. When the laser light irradiation is finished, the substrate 1 is naturally cooled down while keeping the heater on, so that the melted islands are first recrystallized. When the melted silicon island 3A is recrystallized, the substrate 1 contacting the melted silicon island 3A acts as a seed for a single crystal growth providing a (110) plane: accordingly, the melted first island 3A is recrystallized to become a single crystal 3AR having the same (110) plane. However, when melted second silicon island 3B, separated from the substrate 1, i.e. having no seed, is recrystallized, single crystal growth occurs to provide a crystal structure with the least surface potential energy in regard to the underlying insulating layer, that is to provide a (100) plane; accordingly, the melted second island 3B is recrystallized to become a single crystal island 3BR having a (100) plane. This state is shown in Fig. 3(e).

Next, the cap layer 4 is removed as shown in Fig. 3(f). That is, the $Si_3N_4$ film thereof is removed for instance by a wet etching method including, for example, phosphorous acid solution, and the $SiO_2$ film is removed for instance by a wet etching method including, for example, hydrofluoric acid solution.

Next, the seed portion, i.e. a portion, of the first island, including the opening 2', is separated from the main portion of the island 3AR, using for example a photolithography technique; that is: photoresist is patterned over the islands leaving exposed an island portion to be removed, then the exposed island portion, except the portion 3AR in the opening 2, is removed with a wet etching method, for example, using a mixture of hydrofluoric acid and nitric acid solutions. This state is shown in Fig. 3(f) and Fig. 4(b). Next, in accordance with generally known techniques, a p-channel MOS FET is fabricated in the first island 3AR, having a (110) plane, and an n-channel MOS FET is fabricated in the second island 3BR, so that the two MOS FETs are complementary.

Referring to a completed CMOS structure shown in Fig. 3(h), details of one possible fabrication process will be described.

The first island 3AR is doped with an n-type dopant, such as arsenic, for example to a concentration as high as approximately $10 \times 10^{17}$ $cm^{-3}$. The second island 3BR is doped with a p-type dopant, such as boron, for example to a concentration of approximately $10 \times 10^{17}$ $cm^{-3}$. $SiO_2$ insulating layers 5 and 9 are formed on the thus doped islands 3AR and 3BR, for instance by oxidization of the islands, to form gate insulation. Next, gate electrodes 6 and 10 are formed respectively on the $SiO_2$ layers 5 and 7, by deposition of heavily doped silicon, doped with a dose of up to approximately $10 \times 10^{-12}$ $cm^{-2}$. Then a p-type dopant, such as boron, is ion-implanted, to a dose of as much as approximately $3 \times 10^{-15}$ $cm^{-2}$, into source and drain regions 7 and 8 in the first island 3AR so as to form p-type regions. Next, an n-type dopant, such as arsenic, is ion-implanted into source and drain regions 11 and 12 in the second island 3BR, to a dose of as much as approximately $3 \times 10^{-15}$ $cm^{-2}$, so as to form n-type regions. An insulating $SiO_2$ layer 13 is deposited all over the wafer. The $SiO_2$ layers 5, 9 and 13 are locally etched to form windows exposing parts of each of the source and drain regions. Next, aluminum electrodes 14 are patterned on the $SiO_2$ layer 13 so as to contact the drains and sources through the windows. A plurality of MOS FETs may be fabricated in a single island so that integration density is increased, though this is not shown in the Figures.

Though in the above-described embodiment a seed portion 3AR' is not separated, the area taken up by the seed portion can be saved and integration density increased, as shown in Fig. 4(c). However, if the seed portion is not separated the substrate potential of the p-channel MOS FET is kept at a ground voltage and accordingly the stray capacitance of the p-channel MOS FET may be increased perhaps to result in lower operation speed.

In this embodiment of the present invention, each MOS FET of a complementary pair is formed in a silicon island of crystal orientation offering the higher mobility for the kind of carrier involved in that FET; thus, high-speed operation can be achieved. It is also advantageous that the recrystallization process can be carried out for both (100) and (110) planes using a single laser irradiation process. Furthermore, it is advantageous that the complete insulation between the complementary FETs prevent latch-up effect between the FETs.

When the silicon islands are recrystallized, the crystal should desirably have a single crystal structure, i.e. have no grain boundary. Grain boundaries adversely effect transistor operation.

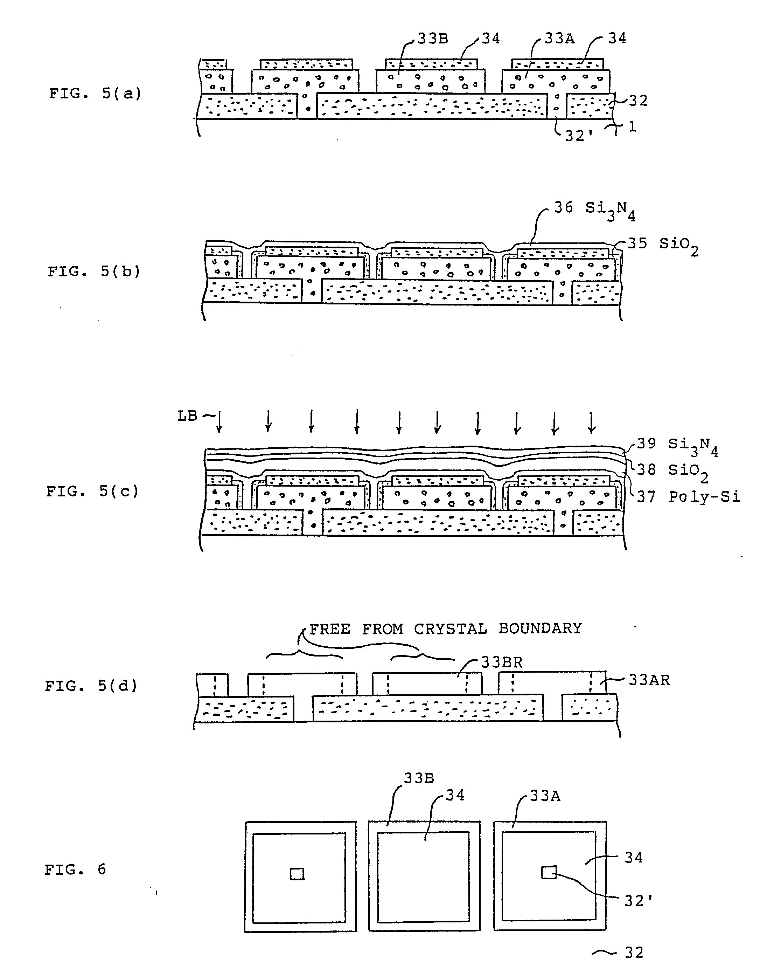

In order to ensure as far as possible that the islands 3AR or 3BR are free from gain boundaries, it is preferable to employ a method which is the subject of a U.S. Patent Application No. 937412 of 1986 assigned to the present applicant. Employment of such a method in an embodiment of the present invention will be described with reference to Figs. 5 and Fig. 6.

In this embodiment islands are arranged as follows: an opening 32', typically 4 $\mu$m square, in an $SiO_2$ layer 32, is located essentially or approximately at the centre of a first island 33A. The islands 33A and 33B have widths, on each side, for example, approximately 5 $\mu$m wider than the widths, 20 x 20 $\mu$m, to be provided for completed single crystal portions. On surfaces of thus sized polycrystalline or amorphous silicon islands 33A and 33B, an approximately 40000 Å (or 4000 Å) thick $SiO_2$ layer 34 is deposited using a CVD technique. Next, the $SiO_2$ layer 34 is patterned so that portions thereof other than those on island parts which will provide completed single crystal portions (with a size 20 x 20 $\mu$m) are removed (for example employing a method involving use of photoresist and an RIE with a $CHF_3$ gas) as shown in Fig. 5-(a).

Next, thus exposed portions of the silicon islands are thermally oxidized to form an approximately 300 Å thick $SiO_2$ film 35.

Next, an approximately 800 Å thick $Si_3N_4$ film 36 is deposited on the patterned $SiO_2$ layer 34 and the $SiO_2$ film 35. This state is shown in Fig. 5(b). On the deposited $Si_3N_4$ film 36 an approximately 7000Å thick polycrystalline or amorphous silicon layer 37 is deposited using a CVD method. On the deposited silicon layer 37 an approximately 300 Å thick $SiO_2$ film 38 and an approximately 300 Å thick $Si_3N_4$ film 39 are

deposited, for instance using the same procedures as those mentioned above. This state is shown in Fig. 5-(c).

The films 38 and 39 reduce reflection of irradiated laser light beam LB in a similar way to the cap layer 4.

Next, while the substrate 1 is heated at approximately 450°C with an electric heater, an argon laser light beam LB, having an approximately 100 μm beam spot, 15 to 13 watt output, and approximately 2.5 cm/sec. scanning speed, is irradiated through the layers 38 and 39 into the silicon layer 37. The silicon is a good absorber of the argon laser light and accordingly the silicon layer 37 is melted. Consequently, the islands 33A and 33B are melted by heat conducted from the melted silicon 37 through the SiO₂ layers 34 and 35. Because the centre SiO₂ layer 34 is thicker than the peripheral SiO₂ film 35, the centre portion of the islands 33A and 33B are slow to melt; in other words, the temperature at the centre portion under the thick SiO₂ layer 34 is lower than at a peripheral portion under the thin SiO₂ film 35. Accordingly, when the melted silicon is recrystallized to form islands 33AR and 33BR, the recrystallization takes place at the centre portion first, then extends to the peripheral portion. It is preferable for the seed portion 22' to be located at the centre of the island 33A in order to initiate the crystal growth from the centre. Owing to this recrystallization process, no or substantially no crystal boundary is produced in the central portion of the islands. If a crystal boundary is produced, it is only in the peripheral portions. This state is shown in Fig. 5-(d). Next, the films and layers 39, 38, 37, 36 and 35 are removed, for example employing the same or similar procedures to those described above in relation to Figs. 3 and 4. On thus exposed boundary-free crystal portions of the islands 33AR and 33BR, FETs are fabricated in the same way as described above. Because thus fabricated MOS FETs are on substantially perfect single crystals, i.e. without crystal boundary, MOS FETs of uniform characteristics can be fabricated with high production yield.

Throughout in the Figures, the final islands are drawn square and symmetric for both (110) and (100) islands, but the islands maybe of any shape, including different and/or asymmetric shapes, according to design requirements.

Numerous modifications and changes will readily occur to those skilled in the art, and it will be appreciated that the invention is not limited to the exact constructions and processes and operations shown and described, and accordingly, all suitable modifications and equivalents may be resorted to.

## Claims

1. A method of fabricating a semiconductor device, comprising the steps of:
forming an insulating layer on a silicon substrate having a surface plane of (110) Miller index;
forming an opening in said insulating layer so as to expose a part of said substrate;
depositing a silicon layer on said insulating layer and said exposed part of said substrate;
dividing said deposited silicon layer into a plurality of islands; a first one of said islands contacting said substrate through said opening; a second one of said islands being isolated from said substrate;
recrystallizing said first and second islands of said deposited silicon, whereby said first island is provided with a (110) plane and said second island is provided with a (100) plane;
forming a p-channel field effect transistor, a channel thereof being formed in said recrystallized first island;
forming an n-channel field effect transistor, a channel thereof being formed in said recrystallized second island.

2. A method as claimed in claim 1, said silicon layer being of amorphous silicon.

3. A method as claimed in claim 1, said silicon layer being of polycrystalline silicon.

4. A method as claimed in claim 1, 2, 3, said step of recrystallizing said first and second islands comprising the steps of:
irradiating a light beam on to the islands so as to melt said islands;
discontinuing said irradiation so as to cool said melted islands.

5. A method as claimed in claim 1, 2, 3 or 4, further comprising, after the step of dividing of said deposited silicon layer, the steps of:
depositing a cap layer on said first and second islands for reducing a reflection of said irradiated light beam, said cap layer being formed of a silicon dioxide layer and a silicon nitride layer.

6. A method as claimed in claim 1, 2, 3, 4 or 5, further comprising, after the step of recrystallizing said islands, the steps of:
operatively separating a portion of said first island, which portion includes said opening in said insulating layer, from said first island.

FIG. 1

FIG. 2

FIG. 3(a)

FIG. 3(b)

FIG. 3(c)

FIG. 3(d)

FIG. 3(e)

FIG. 3(f)

3AR     3BR     3AR

~3

2

1

FIG. 3(g)

3AR     3BR

2

3AR'

1

FIG. 3(h)

14   6   14   14   10   14

13

2

1

7   5   8   11   9   12

3AR'    3AR    3BR    3AR'

FIG. 4(a)

FIG. 4(b)

FIG. 4(c)

FIG. 5(a)

FIG. 5(b)

36 Si₃N₄

35 SiO₂

FIG. 5(c)

LB ~

39 Si₃N₄
38 SiO₂
37 Poly-Si

FIG. 5(d)

FREE FROM CRYSTAL BOUNDARY

33BR

33AR

FIG. 6

33B

34

33A

34

32'

32